# EUROPEAN PATENT SPECIFICATION

(11) **EP 2 523 222 B1**
(45) Date of publication and mention of the grant of the patent: **04.03.2020**
(21) Application number: 11731933.5
(22) Date of filing: 06.01.2011
(51) Int. Cl.: H01L 31/042, H01L 27/142

(54) **SOLAR PHOTOVOLTAIC DEVICE AND A PRODUCTION METHOD FOR THE SAME**
SOLAR-PHOTOVOLTAIK-VORRICHTUNG UND HERSTELLUNGSVERFAHREN DAFÜR
DISPOSITIF PHOTOVOLTAÏQUE SOLAIRE ET SON PROCÉDÉ DE FABRICATION

(30) Priority: 06.01.2010 KR 20100000994
(43) Date of publication of application: 14.11.2012
(73) Proprietor: LG Innotek Co., Ltd., Seoul, 04637 (KR)
(72) Inventor: JEE, Suk Jae, Seoul 100-714 (KR); PAK, Hi Sun, Seoul 100-714 (KR); LEE, Dong Keun, Seoul 100-714 (KR)
(74) Representative: Novagraaf Technologies
(86) International application number: PCT/KR2011/000093
(87) International publication number: WO 2011/083995

(56) References cited:
- EP-A1- 1 710 844
- EP-A1- 2 093 803
- DE-A1-102007 032 283
- JP-A- 2001 119 043
- JP-A- 2002 094 089
- JP-A- 2002 094 089
- KR-A- 20070 004 593
- KR-A- 20110 035 733
- US-A- 4 981 525

## Description

### [Technical Field]

The embodiment relates to a solar cell apparatus.

### [Background Art]

Recently, as energy consumption is increased, a solar cell has been developed to convert solar energy into electrical energy.

In particular, a CIGS-based cell, which is a PN hetero junction apparatus having a substrate structure including a glass substrate, a metallic back electrode layer, a P type CIGS-based light absorbing layer, a high resistance buffer layer, and an N type window layer, has been extensively used.

### [Disclosure]

### [Technical Problem]

The embodiment of the invention provides a solar cell apparatus, capable of blocking leakage current and representing improved photoelectric transformation efficiency.

### [Technical Solution]

According to the embodiment of the invention, there is provided a solar cell apparatus as defined in claim 1.

Further embodiments of the invention are defined in claims 2 - 5.

### [Advantageous Effects]

The solar cell apparatus according to an example useful for understanding the present invention includes a barrier layer. The lateral side of the light absorbing part can be insulated by the barrier layer. Therefore, the solar cell apparatus can block leakage current through the lateral side of the light absorbing part.

Therefore, according to the solar cell apparatus of the example, leakage current can be blocked and improved power generation efficiency can be obtained.

In particular, the barrier layer can include zinc oxide that is not doped with impurities, so that the barrier layer represents high resistance. Therefore, the barrier layer can effectively block the leakage current.

In addition, an additional layer need not be formed in order to form the barrier layer. In other words, the barrier layer can be formed when the high resistance buffer is formed. Therefore, the solar cell apparatus having the improved electrical characteristic can be easily provided.

Document JP 2002 094089 A discloses a thin-film solar cell device provided with a light absorption layer and a buffer layer. A through hole is formed in the light absorption layer on a back side electrode. The buffer layer is provided on top of the light absorption layer and along a lateral side thereof. A window layer is formed on the buffer layer and the window layer fills the through hole as to contact the back side electrode.

Solar cell devices are also known from US 4 981 525 A, DE 10 2007 032283 A1, EP 2 093 803 A1 and EP 1 710 844 A1.

### [Description of Drawings]

FIG. 1 is a plan view showing a solar cell apparatus according to the embodiment;
FIG. 2 is a sectional view taken along line A-A' of FIG. 1; and
FIGS. 3 to 7 are sectional views showing a method for manufacturing the solar cell apparatus.

### [Best Mode]

### [Mode for Invention]

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

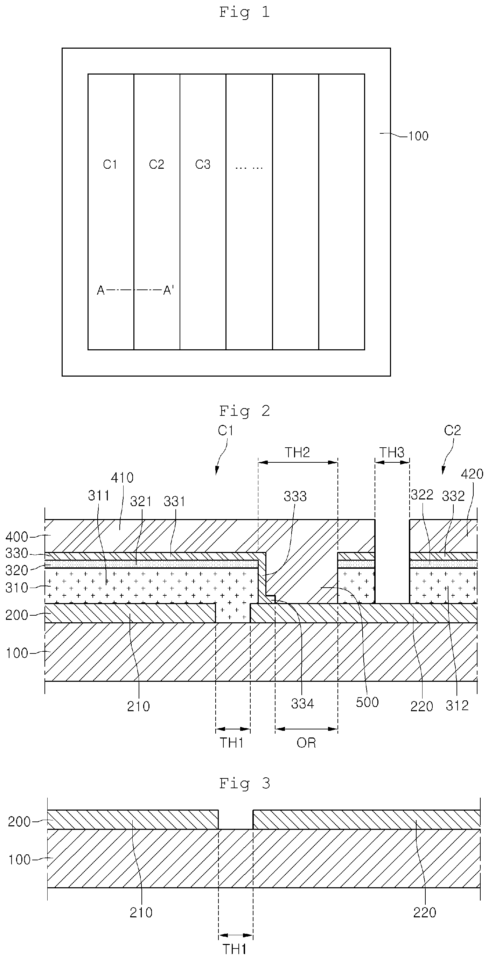

FIG. 1 is a plan view showing a solar cell apparatus according to the embodiment, and FIG. 2 is a sectional view taken along line A-A' of FIG. 1.

Referring to FIGS. 1 and 2, the solar cell apparatus includes a support substrate 100, a back electrode layer 200, a light absorbing layer 310, a buffer layer 320, a high resistance buffer layer 330, a barrier layer 333, a window layer 400, and a connection part 500.

The support substrate 100 has a plate shape, and supports the back electrode layer 200, the light absorbing layer 310, the buffer layer 320, the high resistance buffer layer 330, the window layer 400, and the connection part 500.

The support substrate 100 may include an insulating material. For instance, the support substrate 100 may be a glass substrate, a plastic substrate or a metal substrate. In detail, the support substrate 100 may include a soda lime glass substrate . In addition, the support substrate 100 may be transparent. The support substrate 100 may be rigid or flexible.

The back electrode layer 200 is provided on the support substrate 100. The back electrode layer 200 is a conductive layer. A material constituting the back electrode layer 200 may include metal such as molybdenum (Mo).

The back electrode layer 200 may include at least two layers. In this case, the layers constituting the back electrode layer 200 may include the same material or different materials.

The back electrode layer 200 is provided therein with first through holes TH1. The through hole TH1 is an open region to expose the top surface of the support substrate 100. When viewed in a plan view, the first through hole TH1 may extend in one direction.

The first through hole TH1 has a width in the range of about 80*µ*m to about 200*µ*m.

The back electrode layer 200 is divided into a plurality of back electrodes 210, 220, ..., and 22N by the first through hole TH1. In other words, the back electrodes 210, 220, ..., and 22N are defined by the first through hole TH1. In FIG. 3, only the first and second back electrodes 210 and 220 among the back electrodes 210, 220, ..., and 22N are shown.

The back electrodes 210, 220, ..., and 22N are spaced apart from each other by the first through hole TH1. The back electrodes 210, 220, ..., and 22N are arranged in the form of a strip.

In addition, the back electrodes 210, 220, ..., and 22N may be arranged in the form of a matrix. In this case, when viewed in a plan view, the first through hole TH1 may be provided in the form of a lattice.

The light absorbing layer 310 is provided on the back electrode layer 200. In addition, material constituting the light absorbing layer 310 is filled in the first through hole TH1.

The light absorbing layer 310 may include group I-III-VI-based compounds. For example, the light absorbing layer 310 may have a Cu-In-Ga-Se (Cu (In, Ga) Se₂; CIGS)-based crystal structure, a Cu-In-Se-based crystal structure, or a Cu-Ga-Se-based crystal structure.

The energy band gap of the light absorbing layer 310 may be in the range of about 1.eV to about 1.8eV.

The buffer layer 320 is provided on the light absorbing layer 310. The buffer layer 320 includes cadmium sulfide (CdS), and the energy band gap of the buffer layer 320 is in the range of about 2.2eV to about 2.4eV.

The light absorbing layer 310 and the buffer layer 320 are formed therein with second through holes TH2. The second through holes TH2 are formed through the light absorbing layer 310 and the buffer layer 320. In addition, the second through holes TH2 are open regions to expose the top surface of the back electrode layer 200.

The second through holes TH2 are adjacent to the first through holes TH1. In other words, when viewed in a plan view, portions of the second through holes TH2 are formed beside the first through holes TH1.

Each second through holes TH2 may have a width in the range of about 80µm to about 200µm.

The light absorbing layer 310 defines a plurality of light absorbing parts 311, 312, ..., and 31N by the second through holes TH2. In other words, the light absorbing layer 310 is divided into the light absorbing parts 311, 312, ..., and 31N by the second through holes TH2.

Similarly, the buffer layer 320 defines a plurality of buffers 321, 322, ..., and 32N by the second through holes TH2.

The high resistance buffer layer 330 is provided on the buffer layer 320. In addition, the high resistance buffer layer 330 is provided inside the second through hole TH2. The high resistance buffer layer 330 includes zinc oxide (i-ZnO) that is not doped with impurities. The high resistance buffer layer 330 has energy band gap in the range of about 3.1eV to about 3.3eV.

The high resistance buffer layer 330 has high resistance. In detail, the high resistance buffer layer 330 has resistance higher than those of the window layer 400 and the connection part 500. In more detail, the high resistance buffer layer 330 may have resistance about 10⁵ times to about 10⁷ times greater than those of the window layer 400 and the connection part 500. The high resistance buffer layer 330 may have a thickness in the range of about 20nm to about 100nm.

The high resistance buffer layer 330 is divided into a plurality of high resistance buffer layers 331, 332, ..., and 33N, the barrier layer 333, and a dummy part 334 by an open region overlapping with the second through hole TH2.

The open region OR expose the top surface of the back electrode layer 200 by removing a portion of the high resistance buffer layer 330. The open region OR may be offset from the second through hole TH2. In other words, the center of the open region OR may be offset from the center of the second through hole TH2.

The open region OR may have a width narrower than that of the second through hole TH2.

The barrier layer 333 extends from the high resistance buffer 331 provided on the first light absorbing part 311, so that the barrier layer 333 is provided on the lateral side of the first light absorbing part 311. The barrier layer 333 is formed integrally with the first high resistance buffer 331, and interposed between the first light absorbing part 311 and the connection part 500.

The barrier layer 333 has high resistance similarly to that of the first high resistance buffer 331. In other words, the barrier layer 333 has resistance higher than that of the connection part 500. In detail, the barrier layer 333 may have resistance about 10⁵ to about 10⁷ times greater than that of the connection part 500. For example, the barrier layer 333 has resistance in the range of about 50MΩ to about 200MΩ.

The barrier layer 333 has a thickness in the range of about 20nm to about 100nm similarly to that of the high resistance buffer layer 330.

The dummy part 334 extends along the top surface of the back electrode layer 200 from the barrier layer 333. In detail, the dummy part 334 extends from the barrier layer 333 while making contact with the top surface of the second back electrode 220. The dummy part 334 is formed integrally with the barrier layer 333.

The window layer 400 is provided on the high resistance buffer layer 330. The window layer 400 is transparent, and includes a conductive layer. For example, material constituting the window layer 400 may include Al doped ZnO (AZO).

The window layer 400 is provided therein with third through holes TH3. The third through hole TH3 is an open region to expose the top surface of the back electrode layer 200. For example, the third through hole TH3 has a width in the range of about 80*µ*m to about 200*µ*m.

The third through holes TH3 are adjacent to the second through holes TH2. The third through holes TH3 are formed beside the second through holes TH2. In other words, when viewed in a plan view, the third through holes TH3 are formed beside the second through holes TH2.

The window layer 400 is divided into a plurality of widows 410, 420, ..., and 42N by the third through hole TH3. In other words, the windows 410, 420, ..., and 42N are defined by the third through hole TH3.

The widows 410, 420, ..., and 42N have shapes corresponding to those of the back electrodes 210, 220, ..., and 22N. In other words, the windows 410, 420, ..., and 42N are provided in the form of a strip. In addition, the windows 410, 420, ..., and 42N may be arranged in the form of a matrix.

A plurality of cells C1, C2, ..., and CN are defined by the third through holes TH3. In detail, the cells C1, C2, ..., and CN are defined by the second through hole TH2 and the third through hole TH3. In other words, the solar cell apparatus according to the embodiment is divided into the cells C1, C2,..., and CN by the second and third through holes TH2 and TH3.

In other words, the solar cell apparatus according to the embodiment includes the cells C1, C2, ..., and CN. For example, the solar cell apparatus according to the embodiment includes the first and second cells C1 and C2 provided on the support substrate 100.

The first cell C1 includes the first back electrode 210, the first light absorbing part 311, the first buffer 321, the first high resistance buffer 331, and the first window 410.

The first back electrode 210 is provided on the support substrate 100. The first light absorbing part 311, the first buffer 321, and the first high resistance buffer 331 are sequentially stacked on the first back electrode 210. The first window 410 is provided on the first high resistance buffer 331.

The first back electrode 210 faces the first window 410 while interposing the first light absorbing part 311 between the first back electrode 210 and the first window 410.

The second cell C2 is provided on the support substrate 100 while being adjacent to the first cell C1. The second cell C2 includes the second back electrode 220, the second light absorbing part 312, the second buffer 322, the second high resistance buffer 332, and the second window 420.

The second back electrode 220 is provided on the support substrate 100 while being spaced apart from the first back electrode 210. The second light absorbing part 312 is provided on the second back electrode 220 while being spaced apart from the first light absorbing part 311. The second window 420 is provided on the second high resistance buffer 332 while being spaced apart from the first window 410.

The second light absorbing part 312 and the second window 420 expose a portion of the top surface of the second back electrode 220 while covering the second back electrode 220.

The connection part 500 is provided inside the second through hole TH2.

The connection part 500 extends downward from the window layer 400 while directly making contact with the back electrode layer 200. For example, the connection part 500 extends downward from the first window 410 to directly make contact with the second electrode 220.

Accordingly, the connection part 500 connects windows and back electrodes, which constitute the cells C1, C2, ..., and CN adjacent to each other, with each other. In other words, the connection part 500 connects the first window 410 with the second back electrode 220.

The connection part 500 is formed integrally with the windows 410, 420, ..., and 42N. In other words, material constituting the connection part 500 is the same as material constituting the window layer 400.

As described above, the barrier layer 333 has high resistance. Accordingly, the barrier layer 333 insulates the lateral side of the connection part 500. In addition, the barrier layer 333 insulates the lateral sides of the light absorbing parts 311, 312, ..., and 31N.

The barrier layer 333 can be interposed between the light absorbing parts 311, 312, ..., and 31N and the connection parts 500 to block leakage current between the lateral side of the light absorbing parts 311, 312, ..., and 31N and the connection parts 500. For example, the barrier layer 333 can block leakage current flowing from the connection part 500 to the first back electrode 210 through the lateral side of the first light absorbing part 311.

Therefore, the solar cell apparatus according to the embodiment can represent improved electrical characteristics.

In addition, it is unnecessary to sufficiently increase the width of the first through hole TH1 in order to block the leakage current. In other words, even if the width of the first through hole TH1 is decreased, the leakage current can be effectively blocked by the barrier layer 333.

Therefore, the width of the first through hole TH1 can be reduced, and a dead zone, in which power generation is impossible, can be reduced in the solar cell apparatus according to the embodiment.

Accordingly, the solar cell apparatus according to the embodiment has improved power generation efficiency.

FIGS. 3 to 7 are sectional views showing a method for manufacturing the solar cell apparatus according to an example useful for understanding the present invention. The method for manufacturing the solar cell apparatus will be described by making reference to the prior description about the solar cell apparatus.

Referring to FIG. 3, the back electrode layer 200 is formed on the support substrate 100. The first through hole TH1 is formed by patterning the back electrode layer 200 . Therefore, the back electrodes 210, 220, ..., and 22N are formed on the support substrate 100. The back electrode layer 200 is patterned by a laser.

The first through hole TH1 exposes the top surface of the support substrate 100 and may have the width in the range of about 80*µ*m to about 200*µ*m.

In addition, an additional layer such as an anti-diffusion layer may be interposed between the support substrate 100 and the back electrode layer 200. In this case, the first through hole TH1 exposes the top surface of the additional layer.

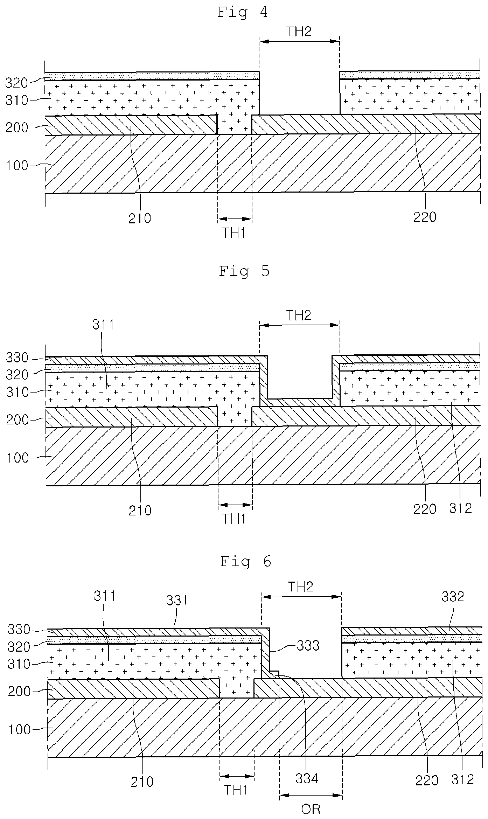

Referring to FIG. 4, the light absorbing layer 310 and the buffer layer 320 are sequentially formed on the back electrode layer 200.

The light absorbing layer 310 may be formed through a sputtering process or an evaporation scheme.

For example, the light absorbing layer 310 may be formed through various schemes such as a scheme of forming a Cu (In, Ga) Se₂ (CIGS) based-light absorbing layer 310 by simultaneously or separately evaporating Cu, In, Ga, and Se and a scheme of performing a selenization process after a metallic precursor film has been formed.

Regarding the details of the selenization process after the formation of the metallic precursor layer, the metallic precursor layer is formed on the back contact electrode 200 through a sputtering process employing a Cu target, an In target, or a Ga target.

Thereafter, the metallic precursor layer is subject to the selenization process so that the Cu (In, Ga) Se₂ (CIGS) based-light absorbing layer 310 is formed.

In addition, the sputtering process employing the Cu target, the In target, and the Ga target and the selenization process may be simultaneously performed.

In addition, a CIS or a CIG light absorbing layer 310 may be formed through a sputtering process employing only Cu and In targets or only Cu and Ga targets and the selenization process.

Thereafter, the buffer layer 320 may be formed after depositing cadmium sulfide on the light absorbing layer 310 through a sputtering process or a CBD (chemical bath deposition) scheme.

Thereafter, the second through hole TH2 is formed by removing portions of the light absorbing layer 310 and the buffer layer 320.

The second through hole TH2 may be formed by a mechanical device such as a tip or a laser device.

For example, the light absorbing layer 310 and the buffer layer 320 may be patterned by a tip having a width in the range of about 40*µ*m to about 180*µ*m. In addition, the second through hole TH2 may be formed by a laser having a wavelength in the range of about 200nm to about 600nm.

In this case, the second through hole TH2 may have a width in the range of about 100*µ*m to about 200*µ*m. The second through hole TH2 exposes a portion of the top surface of the back electrode layer 200.

Referring to FIG. 5, zinc oxide is deposited on the buffer layer 320 and inside the second through hole TH2 through a sputtering process, thereby forming the high resistance buffer layer 330.

Referring to FIG. 6, a portion of the high resistance buffer layer 330 is removed by a laser or a mechanical scribing process, thereby forming the open region OR. The open region OR partially overlaps with the second through hole TH2. In other words, the open region OR is offset from the second through hole TH2. In detail, the center of the open region OR may be offset from the center of the second through hole TH2.

Therefore, the barrier layer 333 is formed on the lateral side of the light absorbing parts 311, 312, ..., and 31N, and the dummy part 334 may be formed on the back electrode layer 200.

In the process of forming the open region OR, it is difficult to exactly adjust the positions of the scribing pattering or the laser patterning so that only the barrier layer 333 remains . Accordingly, since the high resistance buffer layer 330 is patterned so that a slight marginal part remains, the dummy part 334 is formed. In an example not forming part of the present invention, if the high resistance buffer layer 330 is very accurately patterned through the scribing process so that only the barrier layer 333 remains, the dummy part 334 may be omitted.

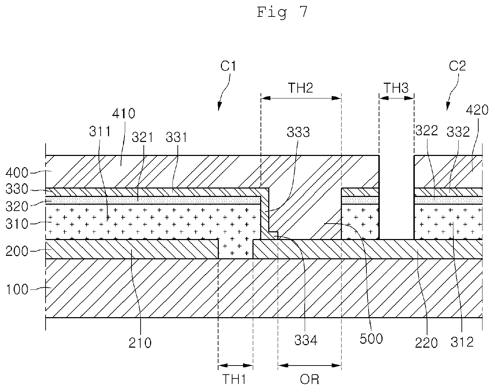

Referring to FIG. 7, the window layer 400 is formed on the high resistance buffer layer 330. In this case, material constituting the window layer 400 is filled in the second through hole TH2.

In order to form the window layer 400, transparent conductive material is stacked on the high resistance buffer layer 330. The transparent conductive material is fully filled in the second through hole TH2. The transparent material may Al-doped zinc oxide.

Therefore, the connection part 500 extending from the window layer 400 to directly make contact with the back electrode layer 200 is formed in the second through hole TH2.

Thereafter, the third through hole TH3 is formed by removing a portion of the window layer 400. In other words, the window layer 400 is patterned, so that the windows 410, 420,..., and 42N and the cells C1, C2,..., and CN are defined.

The third through hole TH3 has a width in the range of about 80*µ*m to about 200*µ*m.

As described above, the barrier layer 333 is formed, thereby providing the solar cell apparatus having high efficiency.

Any reference in this specification to "one embodiment, ""an embodiment, ""example embodiment, "etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the appended claims.

### [Industrial Applicability]

The solar cell apparatus according to the embodiment is applicable to a solar power generation field.

## Claims

1. A solar cell apparatus comprising:
a support substrate (100);
a back electrode layer (200) having a first back electrode (210) on the support substrate and a second back electrode (220) beside the first back electrode (210);
a light absorbing layer (310) provided on the back electrode layer (200); and
a window layer (400) connected to the second back electrode (220),
wherein the back electrode layer (200) has an opening (TH1) between the first back electrode (210) and the second back electrode (220),
wherein the light absorbing layer (310) comprises a through hole (TH2) to a top surface of the second back electrode (220); wherein
the apparatus further comprises a first buffer layer (330) comprising a first part (331) provided on the light absorbing layer (310), a second part (333) provided on a lateral side of the light absorbing layer, and a third part (334) provided on the top surface of the second back electrode (220),
wherein resistance of the first buffer layer (330) is greater than resistance of the window layer (400),
wherein the third part (334) of the first buffer layer has an open region (OR) to the top surface of the second back electrode (220),
wherein the window layer (400) is disposed on the first buffer layer (330) and fills the through hole (TH2),
wherein the second part (333) of the first buffer layer is interposed between the light absorbing layer (310) and the window layer (400) and the second part (333) of the first buffer layer is provided on an internal lateral side of the through hole (TH2),
wherein the open region (OR) is provided in the through hole (TH2),
wherein the open region (OR) has a width smaller than a width of the through hole (TH2).

2. The solar cell apparatus of claim 1, wherein resistance of the first buffer layer (330) is 10⁵ times to 10⁷ times greater than resistance of the window layer (400).

3. The solar cell apparatus of claim 1, wherein the first buffer layer (330) includes zinc oxide.

4. The solar cell apparatus of claim 1, further comprising a second buffer layer (320) interposed between the light absorbing layer (310) and the first part (331) of the first buffer layer (330),
wherein the second part (333) of the first buffer layer covers a lateral side of the second buffer layer (320) and the lateral side of the light absorbing layer (310).

5. The solar cell apparatus of claim 1, wherein a thickness of the second part (333) of the first buffer layer is in a range of 20nm to 100nm.

## Patentansprüche

1. Solarzellgerät, umfassend:
ein Trägersubstrat (100);
eine hintere Elektrodenschicht (200) mit einer ersten hinteren Elektrode (210) auf dem Trägersubstrat und eine zweite hintere Elektrode (220) neben der ersten hinteren Elektrode (210);
eine Licht absorbierende Schicht (310), die auf der hinteren Elektrodenschicht (200) bereitgestellt ist; und
eine Fensterschicht (400), die mit der zweiten hinteren Elektrode (220) verbunden ist,
wobei die hintere Elektrodenschicht (200) eine Öffnung (TH1) zwischen der ersten hinteren Elektrode (210) und der zweiten hinteren Elektrode (220) aufweist,
wobei die Licht absorbierende Schicht (310) ein Durchgangsloch (TH2) zu einer oberen Fläche der zweiten hinteren Elektrode (220) umfasst; wobei das Gerät weiter umfasst
eine erste Pufferschicht (330), die einen ersten Teil (331) umfasst, der auf der Licht absorbierenden Schicht (310) bereitgestellt ist, einen zweiten Teil (333), der auf einer lateralen Seite der Licht absorbierenden Schicht bereitgestellt ist, und einen dritten Teil (334), der auf der oberen Fläche der zweiten hinteren Elektrode (220) bereitgestellt ist,
wobei der Widerstand der ersten Pufferschicht (330) größer als der Widerstand der Fensterschicht (400) ist,
wobei der dritte Teil (334) der ersten Pufferschicht einen Öffnungsbereich (OR) zur oberen Fläche der zweiten hinteren Elektrode (220) aufweist,
wobei die Fensterschicht (400) auf der ersten Pufferschicht (330) angeordnet ist und das Durchgangsloch (TH2) füllt,
wobei der zweite Teil (333) der ersten Pufferschicht zwischen die Licht absorbierende Schicht (310) und die Fensterschicht (400) gestellt ist und der zweite Teil (333) der ersten Pufferschicht auf einer inneren lateralen Seite des Durchgangslochs (TH2) bereitgestellt ist,
wobei der Öffnungsbereich (OR) im Durchgangsloch (TH2) bereitgestellt ist,
wobei der Öffnungsbereich (OR) eine Breite aufweist, die kleiner als eine Breite des Durchgangslochs (TH2) ist.

2. Solarzellgerät nach Anspruch 1, wobei der Widerstand der ersten Pufferschicht (330) 10⁵ Mal bis 10⁷ Mal größer als der Widerstand der Fensterschicht (400) ist.

3. Solarzellgerät nach Anspruch 1, wobei die erste Pufferschicht (330) Zinkoxid einschließt.

4. Solarzellgerät nach Anspruch 1, weiter umfassend eine zweite Pufferschicht (320), die zwischen die Licht absorbierende Schicht (310) und den ersten Teil (331) der ersten Pufferschicht (330) gestellt ist,
wobei der zweite Teil (333) der ersten Pufferschicht eine laterale Seite der zweiten Pufferschicht (320) und die laterale Seite der Licht absorbierenden Schicht (310) abdeckt.

5. Solarzellgerät nach Anspruch 1, wobei eine Dicke des zweiten Teils (333) der ersten Pufferschicht im Bereich von 20 nm bis 100 nm liegt.

## Revendications

1. Appareil à cellules solaires comprenant :
un substrat de support (100) ;
une couche d'électrodes arrière (200) ayant une première électrode arrière (210) sur le substrat de support et une seconde électrode arrière (220) à côté de la première électrode arrière (210) ;
une couche d'absorption de lumière (310) prévue sur la couche d'électrodes arrière (200) ; et
une couche de fenêtre (400) connectée à la seconde électrode arrière (220),
dans lequel la couche d'électrodes arrière (200) a une ouverture (TH1) entre la première électrode arrière (210) et la seconde électrode arrière (220),
dans lequel la couche d'absorption de lumière (310) comprend un trou traversant (TH2) sur une surface de dessus de la seconde électrode arrière (220) ; dans lequel l'appareil comprend en outre
une première couche tampon (330) comprenant une première partie (331) prévue sur la couche d'absorption de lumière (310), une deuxième partie (333) prévue sur un côté latéral de la couche d'absorption de lumière, et une troisième partie (334) prévue sur la surface de dessus de la seconde électrode arrière (220),
dans lequel une résistance de la première couche tampon (330) est supérieure à une résistance de la couche de fenêtre (400),
dans lequel la troisième partie (334) de la première couche tampon a une région ouverte (OR) sur la surface de dessus de la seconde électrode arrière (220),
dans lequel la couche de fenêtre (400) est disposée sur la première couche tampon (330) et remplit le trou traversant (TH2),
dans lequel la deuxième partie (333) de la première couche tampon est interposée entre la couche d'absorption de lumière (310) et la couche de fenêtre (400) et la deuxième partie (333) de la première couche tampon est prévue sur un côté latéral interne du trou traversant (TH2),
dans lequel la région ouverte (OR) est prévue dans le trou traversant (TH2),
dans lequel la région ouverte (OR) a une largeur plus petite qu'une largeur du trou traversant (TH2).

2. Appareil à cellules solaires selon la revendication 1, dans lequel une résistance de la première couche tampon (330) est de 10⁵ fois à 10⁷ fois supérieure à une résistance de la couche de fenêtre (400).

3. Appareil à cellules solaires selon la revendication 1, dans lequel la première couche tampon (330) comporte de l'oxyde de zinc.

4. Appareil à cellules solaires selon la revendication 1, comprenant en outre une seconde couche tampon (320) interposée entre la couche d'absorption de lumière (310) et la première partie (331) de la première couche tampon (330),
dans lequel la deuxième partie (333) de la première couche tampon couvre un côté latéral de la seconde couche tampon (320) et le côté latéral de la couche d'absorption de lumière (310).

5. Appareil à cellules solaires selon la revendication 1, dans lequel une épaisseur de la deuxième partie (333) de la première couche tampon est dans une plage de 20 nm à 100 nm.
